# EUROPEAN PATENT SPECIFICATION

(11) **EP 1 143 467 B1**
(45) Date of publication and mention of the grant of the patent: **15.09.2004**
(21) Application number: 01302514.3
(22) Date of filing: 19.03.2001
(51) Int. Cl.: H01H 1/00, G02B 6/26

(54) **Microelectromechanical actuators including driven arched beams for mechanical advantage**
Mikroelektromechanische Antriebe mit gesteuerten Bogentraversen
Actionneurs micro-électromécaniques à barrettes arquées commandées

(30) Priority: 05.04.2000 US 542672
(43) Date of publication of application: 10.10.2001
(73) Proprietor: Memscap S.A., 38926 Crolles Cedex (FR)
(72) Inventor: Hill, Edward Arthur, Chapel Hill, North Carolina 27514 (US); Dhuler, Viijayakumar Rudrappa, Raleigh, North Carolina 27613 (US); Cowen, Allen Bruce, Morrisville, North Carolina 27560 (US); Mahadevan, Ramaswamy, Chapel Hill, North Carolina 27514 (US); Wood, Robert L., Cary, North Carolina 27502 (US)
(74) Representative: McKechnie, Neil

(56) References cited:
- EP-A- 0 510 629
- US-A- 4 570 139
- US-A- 5 994 816
- US-A- 6 020 564
- QUE L ET AL: "Bent-beam electro-thermal actuators for high force applications" MICRO ELECTRO MECHANICAL SYSTEMS, 1999. MEMS '99. TWELFTH IEEE INTERNATIONAL CONFERENCE ON ORLANDO, FL, USA 17-21 JAN. 1999, PISCATAWAY, NJ, USA,IEEE, US, 17 January 1999 (1999-01-17), pages 31-36, XP010321727 ISBN: 0-7803-5194-0

## Description

### Field of the Invention

This invention relates to microelectromechanical systems (MEMS), and more specifically to MEMS actuators.

### Background of the Invention

Microelectromechanical systems (MEMS) have been developed as alternatives to conventional electromechanical devices, such as relays, actuators, valves and sensors. MEMS devices are potentially low-cost devices, due to the use of microelectronic fabrication techniques. New functionality also may be provided, because MEMS devices can be much smaller than conventional electromechanical devices.

Many applications of MEMS technology use MEMS actuators. These actuators may use one or more beams that are fixed at one or both ends. These actuators may be actuated electrostatically, magnetically, thermally and/or using other forms of energy.

A major breakthrough in MEMS actuators is described in U.S. Patent 5,909,078 entitled *Thermal Arched Beam Microelectromechanical Actuators* to the present inventor et al., the disclosure of which is hereby incorporated herein by reference. Disclosed is a family of thermal arched beam microelectromechanical actuators that include an arched beam which extends between spaced apart supports on a microelectronic substrate. The arched beam expands upon application of heat thereto. Means are provided for applying heat to the arched beam to cause further arching of the beam as a result of thermal expansion thereof, to thereby cause displacement of the arched beam.

Unexpectedly, when used as a microelectromechanical actuator, thermal expansion of the arched beam can create relatively large displacement and relatively large forces while consuming reasonable power. A coupler can be used to mechanically couple multiple arched beams. At least one compensating arched beam also can be included which is arched in a second direction opposite to the multiple arched beams and also is mechanically coupled to the coupler. The compensating arched beams can compensate for ambient temperature or other effects to allow for self-compensating actuators and sensors. Thermal arched beams can be used to provide actuators, relays, sensors, microvalves and other MEMS devices. Thermal arched beam microelectromechanical devices and associated fabrication methods also are described in U.S. Patent 5,955,817 to Dhuler et al. entitled *Thermal Arched Beam Microelectromechanical Switching Array*; U.S. Patent 5,962,949 to Dhuler et al. entitled *Microelectromechanical Positioning Apparatus*; U.S. Patent 5,994,816 to Dhuler et al. entitled *Thermal Arched Beam Microelectromechanical Devices and Associated Fabrication Methods*; and U.S. Patent 6,023,121 to Dhuler et al. entitled *Thermal Arched Beam Microelectromechanical Structure,* the disclosures of all of which are hereby incorporated herein by reference in their entirety.

As MEMS actuators continue to proliferate and to be used in more applications and environments, it would be desirable to allow the displacement and/or force of MEMS actuators to be controlled over wider ranges. Unfortunately, due to the scale of MEMS actuators, only a limited range of displacement and/or force may be obtainable.

A publication entitled *Bent-Beam Electro-Thermal Actuators for High Force Applications* by Que et al., IEEE MEMS '99 Proceedings, pp. 31-36, describes in-plane microactuators fabricated by standard microsensor materials and processes that can generate forces up to about a milli-newton. They operate by leveraging the deformations produced by localized thermal stresses. It is also shown that cascaded devices can offer a four times improvement in displacement.

Furthermore, US-A-6 020 564, wich is considered to be the closest prior art, discloses a micromechanical actuator according to the preamble of claim 1.

Notwithstanding these improvements, there continues to be a need for MEMS actuators that can provide wider ranges of displacement and/or force for various actuator applications.

### Summary of the Invention

In accordance with the present invention there is provided a microelectromechanical actuator as defined in Claim 1.

Microelectromechanical actuators according to embodiments of the invention include a substrate, spaced apart supports on the substrate and a thermal arched beam that extends between the spaced apart supports and that further arches upon heating thereof, for movement along the substrate. A plurality of driven arched beams are coupled to the thermal arched beam. The end portions of the respective driven arched beams move relative to one another to change the arching of the respective driven arched beams in response to the further arching of the thermal arched beam, for movement of the driven arched beams. A respective driven arched beam also includes a respective actuated element at an intermediate portion thereof between the end portions, wherein a respective actuated element is mechanically coupled to the associated driven arched beam for movement therewith, and is mechanically decoupled from the remaining driven arched beams for movement independent thereof. By allowing independent movement of the actuated elements, a variety of actuator applications may be provided wherein it is desired to actuate multiple elements in the same or different directions.

For example, in first embodiments, the plurality of driven arched beams comprise first and second driven arched beams that extend parallel to one another, such that the actuated elements that are mechanically coupled to the first and second driven arched beams move in a same direction by the further arching of the thermal arched beam.

In other embodiments, the respective end portions are squeezed together by the further arching of the thermal arched beam, to thereby increase arching of the driven arched beam. In alternate embodiments, the end portions are pulled apart by the further arching of the thermal arched beam, to thereby decrease arching of the driven arched beams.

In yet other embodiments, the thermal arched beam includes an intermediate portion between the end portions, and the driven arched beams include intermediate portions between the respective end portions thereof. The intermediate portions of the thermal arched beams are coupled to one of the end portions of the driven arched beams. In first embodiments, the intermediate portion of a second thermal arched beam is coupled to the other of the end portions of the driven arched beams. An H-shaped microelectromechanical actuator thereby is formed, wherein each leg of the H comprises a thermally activated arched beam, and the cross-members of the H comprises mechanically activated driven arched beams. In second embodiments, an anchor is provided that anchors the other end portions of the driven arched beams to the substrate. Thus, only one end of the driven arched beams is driven by a thermal arched beam actuator. These embodiments thereby form microelectromechanical actuators having a T-shape, wherein the cross-member of the T comprises a thermally activated arched beam and wherein the leg of the T comprises mechanically activated arched beams.

In other embodiments of microelectromechanical actuators according to the present invention, the thermal arched beam extends between the spaced apart supports along a first direction on the substrate, and further arches upon heating thereof, for movement along the substrate in a second direction that is orthogonal to the first direction. The driven arched beams extend along the substrate in the second direction and the arching of the driven arched beams is changed in the first direction by the further arching of the thermal arched beam for movement along a substrate in the first direction.

In yet other embodiments, second spaced apart supports are provided on the substrate, and a second thermal arched beam is provided that extends between the second spaced apart supports and that further arches upon heating thereof for movement along the substrate. The driven arched beams are coupled to the first and second thermal arched beams, such that the arching of the driven arched beams is changed by the further arching of the first and second thermal arched beams. More preferably, the intermediate portion of the first thermal arched beam is coupled to one end portion of the respective driven arched beams, and the intermediate portion of the second thermal arched beam is coupled to the other end portion of the respective driven arched beams.

In still other embodiments, the first and second thermal arched beams extend between the respective first and second spaced apart supports along a first direction on the substrate, and further arch upon application of heat thereto, for movement along the substrate in a second direction that is orthogonal to the first direction. The driven arched beams extend along the substrate in the second direction, and the arching of the driven arched beams are changed in the first direction by the further arching of at least one of the thermal arched beams for movement along a substrate in the first direction. In alternative embodiments, the first and second thermal arched beams extend between the respective first and second spaced apart supports along a first direction on the substrate, and further arch upon application of heat thereto, for movement along the substrate in respective opposite directions that are orthogonal to the first direction. The driven arched beams extend along the substrate along the second opposite directions, and the arching of the driven arched beams are changed in the first direction by the further arching of the thermal arched beams, for movement along the substrate in the first direction.

In other alternative embodiments of the present invention, additional mechanical advantage may be provided by coupling the plurality of driven arched beams to other driven arched beams, to provide cascaded devices. In particular embodiments, a second thermal arched beam is provided on the substrate that extends between second spaced apart supports and that further arches upon heating thereof for movement along the substrate. A first driven arched beam is coupled to the first thermal arched beam, wherein the end portions of the first driven arched beam move relative to one another to change the arching of the first driven arched beam in response to the further arching of the first thermal arched beam, for movement of the first driven arched beam along the substrate. A second driven arched beam is coupled to the second thermal arched beam, wherein the end portions of the second driven arched beam move relative to one another to change the arching of the second driven arched beam in response to the further arching of the second thermal arched beam, for movement of the second driven arched beam along the substrate. The plurality of driven arched beams are coupled to the first and second driven arched beams.

In all of the above-described embodiments, an actuator other than a thermal arched beam actuator also may be used. The actuator includes a driver beam that moves along the substrate upon actuation thereof. Multiple actuators also may be used.

Other embodiments of the present invention use at least one driven arched beam that is coupled to at least one thermal arched and that is arched in a direction that is nonparallel to the substrate. The driven arched beam includes end portions that move relative to one another to change the arching thereof in the direction that is nonparallel to the substrate in response to the further arching of the thermal arched beam, for movement of the driven arched beam toward or away from the substrate. As was described above, the end portions may be squeezed together or pulled apart. In other embodiments, the driven arched beam is arched in a direction that is orthogonal to the substrate, the arching of which is changed in the direction that is orthogonal to the substrate by the further arching of the thermal arched beam for movement orthogonal to the substrate. Out-of-plane actuators thereby may be provided. Other embodiments may provide H-shaped actuators, T-shaped actuators, cascaded actuators and/or multiple driven arched beams that are arched in a direction that is nonparallel to the substrate. In all of these embodiments, actuators other than thermal arched beam actuators that include a driver beam that moves parallel to the substrate upon actuation thereof also may be used.

In all of the above-described embodiments, reference to a single beam also shall include multiple beams. Moreover, in all of the above-described embodiments, the microelectromechanical actuator may be combined with a relay contact, an optical attenuator, a variable circuit element, a valve, a circuit breaker and/or other elements for actuation thereby. For example, the thermal arched beam may further arch upon heating thereof by ambient heat of an ambient environment in which the microelectromechanical actuator is present, to thereby provide a thermostat. Variable optical attenuator embodiments also may be provided wherein the actuated element selectively attenuates optical radiation between ends of optical fibers that run along the substrate or through the substrate, in response to actuation of one or more thermal arched beams. In all of the above-described embodiments, a trench also may be provided in the substrate beneath at least one of the driven arched beams, to reduce stiction between the at least one driven arched beam and the substrate.

### Brief Description of the Drawings

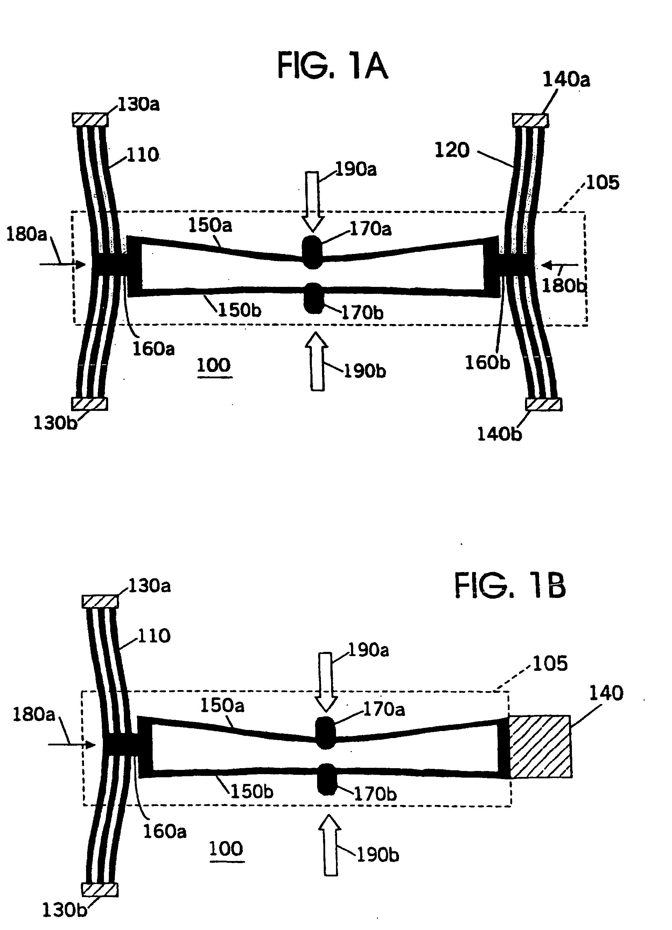

Figures 1A-5B are top views of alternative embodiments of microelectromechanical actuators including driven arched beams for mechanical advantage according to the present invention.

### Detailed Description of Preferred Embodiments

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout. It will be understood that when an element such as a layer, region or substrate is referred to as being "on", "connected to" or "coupled to" another element, it can be directly on, directly connected to or directly coupled to the other element, or intervening elements also may be present. In contrast, when an element is referred to as being "directly on", "directly connected to" or "directly coupled to" another element, there are no intervening elements present.

Many of the embodiments that are described in detail below, employ thermal arched beam (TAB) actuators. The design and operation of TAB actuators are described in the above-cited U.S. Patents 5,909,078, 5,962,949, 5,994,816, 5,995,817 and 6,023,121, the disclosures of all of which are hereby incorporated by reference herein in their entirety, and therefore need not be described in detail herein. However, it will be understood by those having skill in the art that, TABs may be heated by internal and/or external heaters that are coupled to the TAB and/or to the substrate. Moreover, one or more TAB beams may be coupled together and may be supported by one or more pairs of supports. Accordingly, all references to actuation of a TAB actuator shall be construed to cover any thermal actuation technique, all references to thermal arched beams shall be construed as covering one or more thermal arched beams, and all references to a support shall be construed to cover one or more supports that support one or more thermal arched beams.

Finally, in the drawings, fixed supports or anchors are indicated by cross-hatching, whereas movable structures are indicated by solid black. An indication of relative displacement ranges also is provided by using thin arrows for relatively small displacements and thick arrows for relatively large displacements. It also will be understood that these embodiments of microelectromechanical actuators are integrated on an underlying substrate, preferably a microelectronic substrate such as a silicon semiconductor substrate.

Referring now to Figure 1A, embodiments of microelectromechanical actuators according to the present invention are shown. These microelectromechanical actuators may be referred to as "H-TAB" actuators, due to the H-shaped body thereof and the use of thermal arched beams. As shown in Figure 1A, the H-shaped body includes a pair of opposing legs, each of which comprises one or more thermal arched beams **110** and **120,** and a cross-member comprising a plurality of independently moving mechanically activated arched beams **150a** and **150b**.

More specifically, referring to Figure 1A, these embodiments of microelectromechanical actuators include a substrate **100,** a first pair of spaced apart supports **130a** and **130b** on the substrate **100,** at least one first thermal arched beam **110** that extends between the spaced apart supports **130a** and **130b** and that further arches upon application of heat thereto for movement along the substrate in a first direction shown by displacement arrow **180a.** A second pair of spaced apart supports **140a** and **140b** are provided, and at least one second thermal arched beam **120** extends between the second spaced apart supports **140a** and **140b,** and further arches in a second direction that is opposite the first direction, shown by displacement arrow **180b,** upon application of heat thereto for movement along the substrate **100.** A plurality of driven arched beams, here two driven arched beams **150a** and **150b,** are coupled to the first and second thermal arched beams **110** and **120.** In particular, the respective end portions of the driven arched beams **150a** and **150b** are coupled to a respective intermediate portion of a respective thermal arched beam **110** and **120,** for example using respective couplers **160a** and **160b.** A respective driven arched beam **150a** and **150b** also includes a respective actuated element **170a** and **170b** at an intermediate portion thereof between the end portions. A respective actuated element **170a** and **170b** is mechanically coupled to the associated driven arched beam **150a** and **150b,** respectively, for movement therewith. A respective actuated element **170a** and **170b** is mechanically decoupled from the remaining driven arched beams, for movement independent thereof.

Thus, as shown in Figure 1A, upon heating of either or both of the thermal arched beam(s) **110** and **120,** the end portions of the driven arched beam(s) **150a** and **150b** are squeezed together, to thereby increase arching of the driven arched beams. A relatively small amount of displacement in the first or second opposite directions shown by displacement arrows **180a** and/or **180b** respectively, can cause a relatively large movement of the actuated elements **170a** and **170b** in third opposite directions shown by respective displacement arrows **190a** and **190b,** that are orthogonal to the first or second directions shown by displacement arrows **180a** and **180b.** A mechanical advantage thereby may be obtained, and a wider range of displacements may be provided.

As also shown in Figure 1A, a trench **105** optionally may be provided in the substrate **100** beneath at least one of the driven arched beams **150a** and **150b.** The trench can reduce stiction between the at least one driven arched beam and the substrate. A trench also may be provided beneath the thermal arched beam(s) **180a** and/or **180b** to reduce stiction and/or for thermal isolation. The optional trench **105** also is shown in Figure 16. Although it also may be included in the other embodiments described below, it is not illustrated to simplify the drawings.

Still referring to Figure 1A, in the H-TAB geometry, the side TAB actuators **110** and **120,** which are oriented to actuate toward each other, can provide sufficient force, upon heating, to compress the center arched beam(s) **150,** and cause significant deflection of the actuated elements **170** attached to the center beams. Thus, the device may be described as a mechanism for changing mechanical advantage. In particular, the relatively large force and small displacement actuation of the side actuators **110/120** is converted to a relatively low force and relatively large displacement actuation in the center beam **150.** Displacement of 100µm may be achieved with applied power less than 0.5 watts in silicon-based versions of embodiments of these actuators.

Figure 1B illustrates other embodiments wherein only one end portion of the respective driven arched beams are driven by a thermal arched beam(s). Thus, T-TAB geometries are provided, wherein the leg of the T-shaped body comprises a plurality of mechanically activated arched beams **150a** and **150b,** and the cross-member of the T-shaped body comprises at least one thermal arched beam **110.** More specifically, the thermal arched beam(s) **110** extend on a substrate **100** between spaced apart supports **130a** and **130b,** for movement along a direction shown by displacement arrow **180a,** upon thermal actuation thereof. The intermediate portion(s) of the thermal arched beams **110** are coupled to an end portion of the driven arched beams **150a** and **150b,** for example using a coupler **160a.** The other end(s) of the driven arched beams **150a** and **150b** are fixedly anchored by at least one anchor **140.** Multiple driven arched beams **150a** and **150b** include actuated elements **170a** and **170b** respectively. As shown, the actuated elements **170a** and **170b** move in a displacement direction shown by arrows **190a** and **190b,** respectively, upon movement of the intermediate portion of the thermal arched beams **110** in a displacement direction shown by arrow **180a.** A mechanical advantage may be obtained as shown by displacement arrows **190a** and **190b**.

The embodiments of Figure 1B may be regarded as single-side versions of the H-TAB actuator shown in Figure 1A, and may referred to as a T-TAB. The T-TAB can work similarly to the H-TAB, but may have different power/displacement performance characteristics. The device also may have a smaller footprint than an H-TAB of Figure 1A. An application of Figures 1A and 1B can cause the two actuated elements **170a** and **170b** that are coupled to the respective driven beams **150a** and **150b,** to actuate toward one another and contact one another, thereby providing a switch. Many other applications may be envisioned.

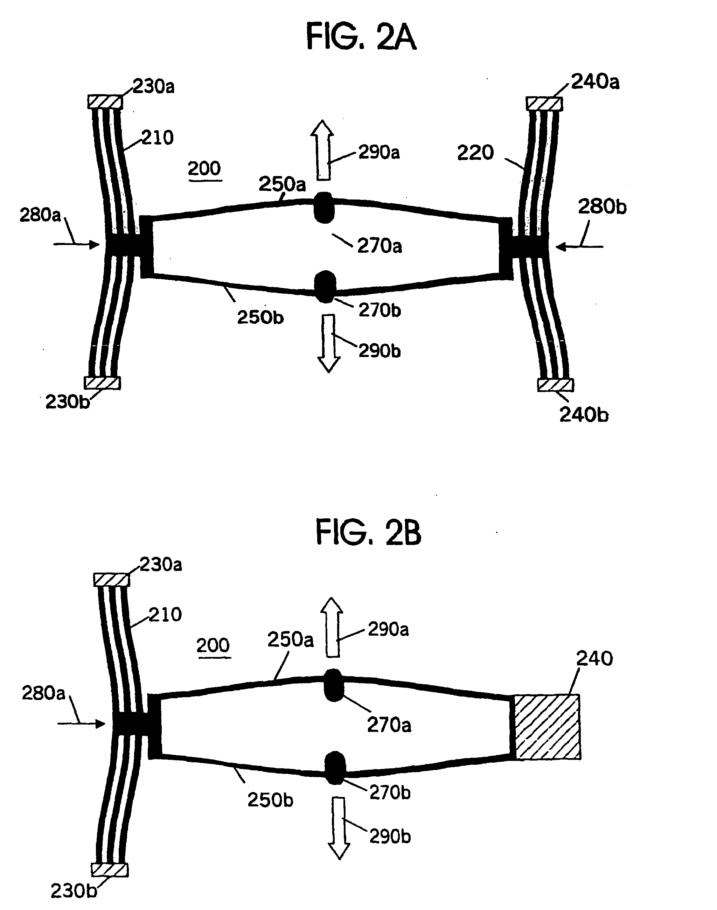

Figure 2A illustrates alternative embodiments of microelectromechanical actuators wherein the first and second driven arched beams **250a** and **250b** further arch away from one another in opposite directions **290a** and **290b,** to cause actuated elements **270a** and **270b** to move away from one another, in response to actuation of first and second thermal arched beams **210** and **220** that extend between spaced apart supports **230a, 230b** and **240a, 240b** on a substrate **200.** The thermal arched beams **210** and **220** actuate toward each other in the directions indicated by displacement arrows **280a** and **280b**.

Figure 2B illustrates analogous embodiments wherein at least one thermal arched beam **210** is used to couple to one end of the driven arched beams **250a** and **250b.** The other end of driven arched beams **250a** and **250b** is fixed by a fixed anchor **240**.

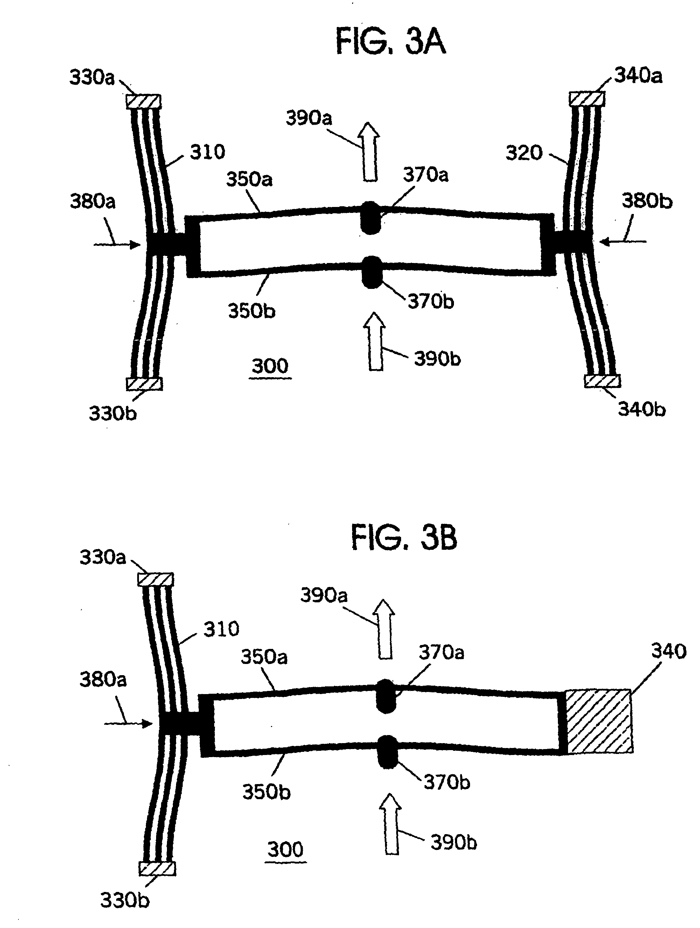

Figure 3A illustrates other embodiments wherein the first and second driven arched beams **350a** and **350b** extend parallel to one another between the first thermal arched beam(s) **310** and the second thermal arched beam(s) **320** that extend between pairs of spaced apart supports **330a, 330b** and **340a, 340b** on a substrate **300.** Thus, in response to actuation of the first and second thermal arched beams **310** and **320** in the first and second opposite directions shown by displacement arrows **380a** and **380b,** the first and second driven arched beams both actuate in the same direction indicated by displacement arrows **390a** and **390b.** The actuated elements **370a** and **370b** move relative to the substrate, but not relative to one another when the driven arched beams are the same size and scope. Embodiments of Figure 3A can be used for parallel contacts such as parallel current pads in microrelay or other applications. Many other applications can be envisioned. Multiple actuated elements may have many applications in optical shutter and/or electrical relay technology.

Figure 3B illustrates embodiments that are similar to Figure 3A, except that the first and second driven arched beams **350a** and **350b** are driven only at one end and are maintained fixed at the other end by a fixed anchor 340.

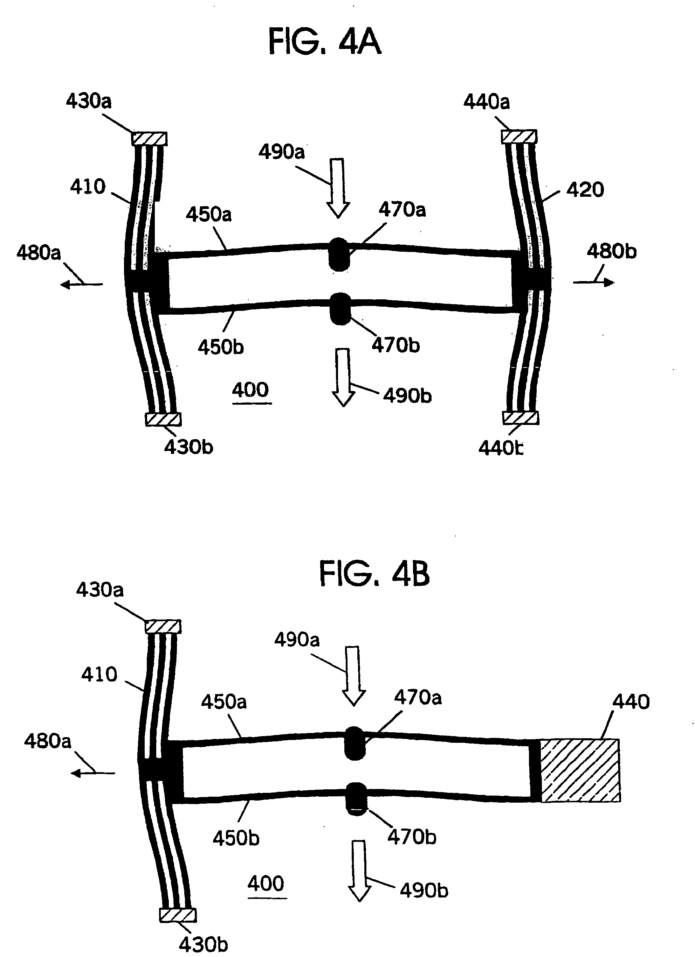

Referring now to Figure 4A, other alternate embodiments of microelectromechanical actuators according to the present invention are shown. Figure 4A may be contrasted with Figures 1A-3A, because the end portions of the driven arched beams are pulled apart by further arching of the thermal arched beam(s), to thereby decrease arching of the driven arched beams. In particular, as shown in Figure 4A, first and second thermal arched beam(s) **410** and **420** respectively, arch in opposite directions shown by displacement arrows **480a** and **480b** and extend between first and second pairs of spaced apart supports **430a, 430b** and **440a, 440b** on a substrate **400.** Accordingly, activation of the thermal arched beams **410** and **420** causes the thermal arched beams to further arch in the opposite directions indicated by displacement arrows **480a** and **480b,** away from each other. This causes the arching in the driven beams **450a** and **450b** to decrease, thereby displacing actuated elements **470a** and **470b** in the direction shown by displacement arrows **490a** and **490b**.

It will be understood that Figure 4A illustrates embodiments wherein two driven arched beams **450a** and **450b** that extend parallel to one another in a manner similar to Figure 3A. However, the driven arched beams **450a** and **450b** may arch toward one another in a manner similar to Figure 1A or away from each other in a manner similar to Figure 2A.

Figure 4B illustrates similar T-TAB actuators, except that the driven arched beams **450a** and **450b** are driven at one end and are maintained fixed at the other end by an anchor **440.** It will be understood that, similar to Figure 4A, embodiments of driven arched beams analogous to Figures 1B-3B also may be provided.

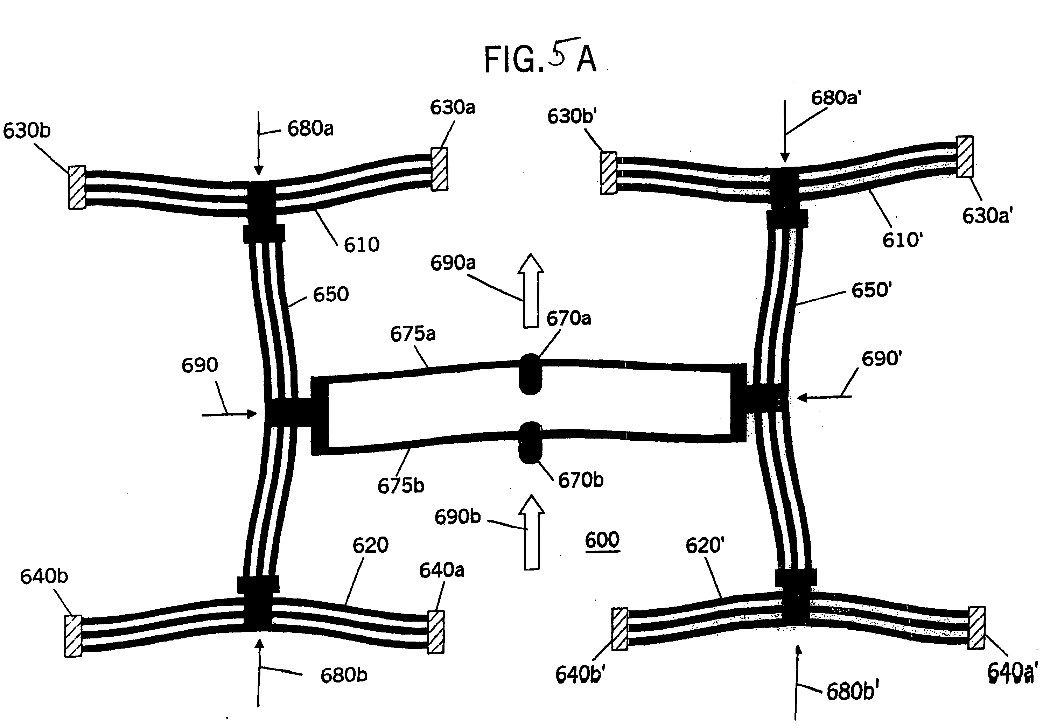

Figures 5A and 5B illustrate yet other embodiments wherein the driven arched beams of first and second spaced apart thermal arched beam actuators are themselves coupled together by another driven arched beam(s). These cascaded configurations may be used to obtain extremely large displacements or to obtain other improved performance properties such as lower power usage.

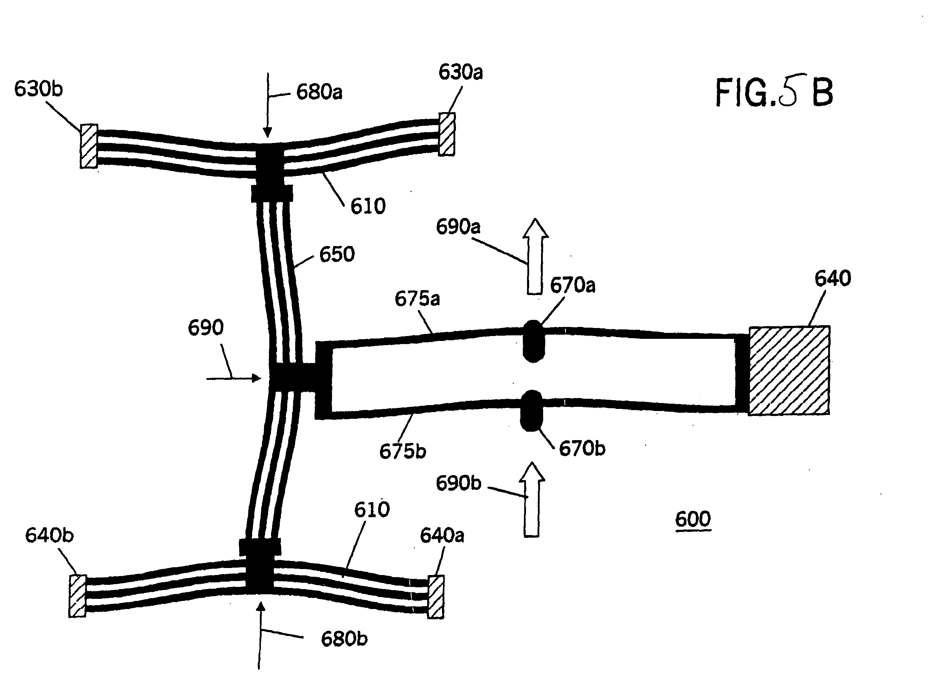

In particular, referring to Figure 5A, a first driven arched beam(s) **650** is driven at the end thereof by first and second thermal arched beams **610** and **620** that extend between spaced apart supports **630a, 630b** and **640a, 640b** on a substrate **600**. Arching of the first and second thermal arched beams **610** and **620** in the directions shown by displacement arrows **680a** and **680b** squeezes the ends of the driven arched beams **650a** and **650b** to cause displacement of the actuated elements **675a** and **675b** in the directions shown by displacement arrows **690a** and **690b**. A mirror image of this structure is provided, including third and fourth thermal arched beams **610'** and **620'** and a second driven arched beam(s) **650'**, with the corresponding elements indicated by prime notation. At least one third driven arched beam **675** is coupled between the first and second driven arched beams **650** and **650'**. More specifically, the ends of the third driven arched beam(s) **675** are coupled between the intermediate portions of the first and second thermal arched beam(s) **650** and **650'**. Upon actuation of the first, second, third and fourth thermal arched beams **610, 620, 610'** and **620'**, the ends of the third driven arched beam(s) **650a** and **650b** may be squeezed by a large amount due to the displacement amplification provided by the first and second driven arched beams **650** and **650'**, to thereby provide a large displacement of contact **670** in the direction shown by arrow **695.** It will be understood that each of the actuators of Figure 6A may be embodied using any of the previously described embodiments and the third driven arched beam(s) **675a** and **675b** also may be embodied using any of the previously described embodiments. It also will be understood that not all of thermal arched beams **610, 620, 610'** and **620'** need be actuated simultaneously.

Figure 5B is similar to Figure 5A, except it describes a third driven arched beam that is driven at one end only by an H-TAB actuator. The other end of the third driven arched beams **675** is fixed by an anchor **640**.

There can be many uses for embodiments of microelectromechanical actuators according to the present invention. Optical applications may be envisioned, such as using an H-TAB actuator to drive variable optical attenuators and/or optical crossconnect switching devices. Electrical and/or radio frequency applications, such as using an H-TAB actuator to drive a microrelay or variable capacitor/inductor also may be provided. A thermostat may be provided wherein the thermal arched beam further arches upon heating thereof by ambient heat of an ambient environment in which the microelectromechanical actuator is present. Other applications, such as using these actuator arrays for microfluidic control or micropneumatic control, may be provided. Accordingly, one or more of the driven arched beams may be coupled to other elements, such as relay contacts, optical attenuators, variable circuit elements such as resistors and capacitors, valves and circuit breakers. Many other configurations and applications that use cascaded arched beams, both thermal and mechanical in order to change mechanical advantage also may be provided.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A microelectromechanical actuator comprising:
a substrate (100); and
an actuator on the substrate that includes a driver beam (110) that moves along the substrate upon actuation of the actuator;
a plurality of driven arched beams (150) that are coupled to the driver beam (110), a respective driven arched beam (150) including end portions that move relative to one another to change the arching of the respective driven arched beam in response to the movement of the driver beam along the substrate, a respective driven arched beam also including a respective actuated element (170) at an intermediate portion thereof between the end portions, wherein the respective actuated element is mechanically coupled to the associated driven arched beam for movement therewith **characterised in that** the respective actuated element is mechanically decoupled from remaining driven arched beams for movement independent thereof.

2. A microelectromechanical actuator according to Claim 1 further **CHARACTERIZED BY** the plurality of driven arched beams comprising first and second driven arched beams (350a, 350b) that extend parallel to one another such that the actuated elements (370a, 370b) that are mechanically coupled to the first and second driven arched beams move in a same direction (390a, 390b) by the movement of the driver beam.

3. A microelectromechanical actuator according to Claim 1 further **CHARACTERIZED BY** the plurality of driven arched beams comprising first and second driven arched beams (250a, 250b) that arch away from one another such that the actuated elements (270a, 270b) that are coupled to the first and second driven arched beams move in opposite directions (290a, 290b) by the movement of the driver beam.

4. A microelectromechanical actuator according to Claim 1 further **CHARACTERIZED BY** the plurality of driven arched beams comprising first and second driven arched beams (150a, 150b) that arch toward one another such that the actuated elements (170a, 170b) that are mechanically coupled to the first and second driven arched beams move in opposite directions (190a, 190b) by the movement of the driver beam.

5. A microelectromechanical actuator according to Claims 1, 2, 3 or 4 further **CHARACTERIZED BY** a trench (105) in the substrate beneath at least one of the plurality of driven arched beams, to reduce stiction between the at least one of the plurality of driven arched beams and the substrate.

6. A microelectromechanical actuator according to Claims 1, 2, 3 or 4 further **CHARACTERIZED BY** at least one of the driven arched beams being arched in a direction that is nonparallel to the substrate.

## Patentansprüche

1. Mikroelektromechanischer Antrieb, umfassend:
ein Substrat (100) und
einen Antrieb auf dem Substrat, der einen Treiberträger (110) hat, der sich bei Betätigung des Antriebs am Substrat entlang bewegt,
eine Mehrzahl von gesteuerten Bogentraversen (150), die mit dem Treiberträger (110) verbunden sind, wobei eine jeweilige gesteuerte Bogentraverse (150) Endteile hat, die sich relativ zueinander bewegen, um die Krümmung der jeweiligen gesteuerten Bogentraverse in Reaktion auf die Bewegung des Treiberträgers am Substrat entlang zu ändern, wobei eine jeweilige gesteuerte Bogentraverse auch ein jeweiliges betätigtes Element (170) an einem Zwischenteil davon zwischen den Endteilen hat, wobei das jeweilige betätigte Element mechanisch mit der assoziierten gesteuerten Bogentraverse verbunden ist zur Bewegung damit, **dadurch gekennzeichnet, dass** das jeweilige betätigte Element mechanisch von übrigen gesteuerten Bogentraversen getrennt ist zur davon unabhängigen Bewegung.

2. Mikroelektromechanischer Antrieb nach Anspruch 1, ferner **dadurch gekennzeichnet, dass** die Mehrzahl von gesteuerten Bogentraversen erste und zweite gesteuerte Bogentraversen (350a, 350b) umfasst, die sich parallel zueinander erstrecken, sodass die betätigten Elemente (370a, 370b), die mechanisch mit den ersten und zweiten gesteuerten Bogentraversen verbunden sind, sich durch die Bewegung des Treiberträgers in der gleichen Richtung (390a, 390b) bewegen.

3. Mikroelektromechanischer Antrieb nach Anspruch 1, ferner **dadurch gekennzeichnet, dass** die Mehrzahl gesteuerter Bogentraversen erste und zweite gesteuerte Bogentraversen (250a, 250b) umfasst, die sich voneinander weg krümmen, sodass sich die betätigten Elemente (270a, 270b), die mit den ersten und zweiten gesteuerten Bogentraversen verbunden sind, durch die Bewegung der Treibertraverse in entgegengesetzten Richtungen (290a, 390b) bewegen.

4. Mikroelektromechanischer Antrieb nach Anspruch 1, ferner **dadurch gekennzeichnet, dass** die Mehrzahl von gesteuerten Bogentraversen erste und zweite gesteuerte Bogentraversen (150a, 150b) umfasst, die sich aufeinander zu krümmen, sodass die betätigten Elemente (170a, 170b), die mechanisch mit den ersten und zweiten gesteuerten Bogentraversen verbunden sind, sich durch die Bewegung des Treiberträgers in entgegengesetzten Richtungen (190a, 190b) bewegen.

5. Mikroelektromechanischer Antrieb nach einem der Ansprüche 1, 2, 3 oder 4, ferner **gekennzeichnet durch** einen Graben (105) im Substrat unter wenigstens einer der Mehrzahl von gesteuerten Bogentraversen zum Verringern von Haftreibung zwischen wenigstens einer der Mehrzahl von gesteuerten Bogentraversen und dem Substrat.

6. Mikroelektromechanischer Antrieb nach einem der Ansprüche 1, 2, 3 oder 4, ferner **dadurch gekennzeichnet, dass** wenigstens eine der gesteuerten Bogentraversen in einer Richtung gekrümmt ist, die nicht parallel zu dem Substrat ist.

## Revendications

1. Actionneur microélectromécanique comprenant :
un substrat (100), et
un actionneur sur le substrat qui inclut une barrette de commande (110) qui se déplace le long du substrat lors de l'actionnement de l'actionneur ;
une pluralité de barrettes arquées commandées (150) qui sont accouplées à la barrette de commande (110), une barrette arquée commandée (150) respective incluant des parties d'extrémité qui se déplacent l'une par rapport à l'autre pour modifier l'arc de la barrette arquée commandée respective en réponse au déplacement de la barrette de commande le long du substrat, une barrette arquée commandée respective incluant également un élément actionné (170) respectif en son milieu entre les parties d'extrémité, dans lequel l'élément actionné respectif est mécaniquement accouplé à la barrette arquée commandée associée pour se déplacer avec celle-ci, **caractérisé en ce que** l'élément actionné respectif est mécaniquement désaccoupler des barrettes arquées commandées restantes pour se déplacer indépendamment de celles-ci.

2. Actionneur microélectromécanique suivant la revendication 1 **caractérisé en outre en ce que** la pluralité de barrettes arquées commandées comprend une première et une deuxième barrettes arquées commandées (350a, 350b) qui s'étendent parallèlement l'une à l'autre de sorte que les éléments actionnés (370a, 370b) qui sont mécaniquement accouplés à la première et à la deuxième barrettes arquées commandées sont déplacés dans une même direction (390a, 390b) par le déplacement de la barrette de commande.

3. Actionneur microélectromécanique suivant la revendication 1 **caractérisé en outre en ce que** la pluralité de barrettes arquées commandées comprend une première et une deuxième barrettes arquées commandées (250a, 250b) qui sont arquées en direction opposée l'une de l'autre de sorte que les éléments actionnés (270a, 270b) qui sont accouplés à la première et à la deuxième barrettes arquées commandées sont déplacés dans des directions opposées (290a, 290b) par le déplacement de la barrette de commande.

4. Actionneur microélectromécanique suivant la revendication 1 **caractérisé en outre en ce que** la pluralité de barrettes arquées commandées comprend une première et une deuxième barrettes arquées commandées (150a, 150b) qui sont arquées en direction l'une de l'autre de sorte que les éléments actionnés (170a, 170b) qui sont mécaniquement accouplés à la première et à la deuxième barrettes arquées commandées sont déplacés dans des directions opposées (190a, 190b) par le déplacement de la barrette de commande.

5. Actionneur microélectromécanique suivant la revendication 1, 2, 3 ou 4 **caractérisé en outre par** une tranchée (105) dans le substrat en dessous d'au moins une barrette parmi la pluralité de barrettes arquées commandées, pour réduire le frottement par adhérence entre la au moins une barrette parmi la pluralité de barrettes arquées commandées et le substrat.

6. Actionneur microélectromécanique suivant la revendication 1, 2, 3 ou 4 **caractérisé en outre en ce qu'**au moins une des barrettes arquées commandées est arquée dans une direction qui est non parallèle au substrat.
